# EUROPÄISCHE PATENTSCHRIFT

(11) **EP 3 066 693 B1**
(45) Veröffentlichungstag und Bekanntmachung des Hinweises auf die Patenterteilung: **12.12.2018**
(21) Anmeldenummer: 14790649.9
(22) Anmeldetag: 30.10.2014
(51) Int. Cl.: H01L 31/02, H02J 3/32, H02J 3/38

(54) **VERFAHREN ZUM BETRIEB EINER PHOTOVOLTAIKANLAGE MIT ENERGIESPEICHER UND BIDIREKTIONALER WANDLER FÜR DEN ANSCHLUSS EINES ENERGIESPEICHERS**
METHOD FOR OPERATING A PHOTOVOLTAIC SYSTEM COMPRISING AN ENERGY STORE AND A BIDIRECTIONAL CONVERTER FOR CONNECTION OF AN ENERGY STORE
PROCÉDÉ DE FONCTIONNEMENT D'UNE INSTALLATION PHOTOVOLTAÏQUE COMPRENANT UN ACCUMULATEUR D'ÉNERGIE ET UN CONVERTISSEUR BIDIRECTIONNEL POUR LA CONNEXION D'UN ACCUMULATEUR D'ÉNERGIE

(30) Priorität: 04.11.2013 DE 102013112077
(43) Veröffentlichungstag der Anmeldung: 14.09.2016
(73) Patentinhaber: SMA Solar Technology AG, 34266 Niestetal (DE)
(72) Erfinder: BERGER, Niels, 34266 Niestetal (DE); HEINZE, Sebastian, 20253 Hamburg (DE)
(74) Vertreter: Lahnor, Peter
(86) Internationale Anmeldenummer: PCT/EP2014/073395
(87) Internationale Veröffentlichungsnummer: WO 2015/063234

(56) Entgegenhaltungen:
- EP-A2- 2 362 519
- DE-A1-102012 002 185
- JP-A- H1 031 525
- US-A1- 2012 261 990
- VELASCO D ET AL: "Photovoltaic power management system with grid connected and islanded operation", INDUSTRIAL ELECTRONICS (ISIE), 2011 IEEE INTERNATIONAL SYMPOSIUM ON, IEEE, 27. Juni 2011 (2011-06-27), Seiten 1471-1476, XP032019270, DOI: 10.1109/ISIE.2011.5984377 ISBN: 978-1-4244-9310-4

## Beschreibung

### TECHNISCHES GEBIET DER ERFINDUNG

Die Erfindung betrifft ein Verfahren zum Betrieb einer Photovoltaikanlage mit einem Energiespeicher, das die Merkmale des Oberbegriffs des unabhängigen Patentanspruchs 1 aufweist. Weiterhin betrifft die Erfindung einen bidirektionalen Wandler für den Anschluss eines Energiespeichers, der ein solches Verfahren umsetzt.

Bei dem Energiespeicher kann es sich insbesondere um einen Akkumulator oder eine Batterie, wie beispielsweise auch eine Kondensatorbatterie handeln. Grundsätzlich kann der Energiespeicher aber auch eine elektrische Maschine und eine Schwungmasse umfassen, um elektrische Energie in Form mechanischer Energie zwischenzuspeichern. Der Energiespeicher kann zudem aus unterschiedlichen Teilenergiespeichern zusammengesetzt sein.

### STAND DER TECHNIK

Da Photovoltaikgeneratoren des Nachts keine und am Tag eine variable, je nach Bewölkungslage sogar kurzfristig schwankende elektrische Leistung bereitstellen, ist die Integration von Energiespeichern für elektrische Energie von besonderem Interesse. Mit derartigen Energiespeichern könnten Photovoltaikanlagen in die Lage versetzt werden, überhaupt des Nachts und am Tag eine gleichbleibende elektrische Leistung bereitzustellen.

Es sind Photovoltaikwechselrichter für Photovoltaikanlagen bekannt, die neben einem Generatoranschluss einen speziellen Batterieanschluss aufweisen, wobei der Batterieanschluss über einen bidirektionalen Wandler an einen Gleichspannungszwischenkreis des Photovoltaikwechselrichters angeschlossen ist. Bei einem solchen, aus der DE 10 2012 109 420 A1 bekannten Photovoltaikwechselrichter ist der bidirektionale Wandler zusätzlich an den Generatoranschluss angeschlossen, um eine an den Batterieanschluss angeschlossene Batterie direkt, d. h. unter Umgehung des Gleichspannungszwischenkreises und eines zwischen den Generatoranschluss und den Gleichspannungszwischenkreis geschalteten DC/DC-Wandlers, mit elektrischer Energie von einem an den Generatoranschluss angeschlossenen Photovoltaikgenerator aufzuladen. Die DE 10 2012 109 420 A1 zeigt keinen Weg auf, einen Photovoltaikwechselrichter, der hierfür nicht von vorn herein eingerichtet ist, auf einfache Weise mit einem Energiespeicher nachzurüsten.

Aus der DE 10 2012 002 185 A1 sind eine Photovoltaikanlage mit Energiespeicher und ein Verfahren zum Betreiben dieses Energiespeichers bekannt. Dabei ist der Energiespeicher über einen Wandler parallel zu einem Photovoltaikgenerator an einen Eingang eines Wechselrichters angeschlossen. Der Energiespeicher kann einen Rotationsspeicher, einen Kondensator, einen Akkumulator und/oder eine Batterie aufweisen. Der Wechselrichter weist einen MPP-Tracker auf, der eine Betriebsspannung an dem Eingang des Wechselrichters vorgibt und zum Nachfolgen einer Betriebsspannung maximaler Leistung von dem Photovoltaikgenerator eingerichtet ist. Damit durch den über den Wandler angeschlossenen Energiespeicher die Funktion des MPP-Trackers nicht gestört wird, wird der Wandler gemäß einer geeignet gewählten Kennlinie betrieben. In einem zusätzlichen Betriebsmodus wird der Wandler dann, wenn beispielsweise des Nachts keine elektrische Leistung von dem Photovoltaikgenerator zur Verfügung steht, mit einer solchen Leistungs-Spannungs-Kennlinie betrieben, dass der MPP-Tracker eine für den Betrieb des Energiespeichers günstige Betriebsspannung an dem Eingang des Wechselrichters einstellt.

Der aus der DE 10 2012 002 185 A1 bekannte Energiespeicher ist mit dem zugehörigen Wandler zwar bei einer vorhandenen Photovoltaikanlage nachrüstbar, indem er parallel zu einem vorhanden Photovoltaikgenerator an einen Eingang des Wechselrichters angeschlossen wird. Er ist im laufenden Betrieb der Photovoltaikanlage aber nur dann mit dem MPP-Tracker des Wechselrichters für den Photovoltaikgenerator kompatibel, wenn eine im Wesentlichen konstante Leistung von dem Energiespeicher an den Wechselrichter abgegeben wird oder von dem Energiespeicher aus dem Photovoltaikgenerator aufgenommen wird.

Aus der US 2012/0261990 A1 sind eine Photovoltaikanlage mit einem Photovoltaikgenerator, einem Wechselrichter und einer Batterie und ein Verfahren zum Betreiben einer Photovoltaikanlage bekannt. Dabei wird ein Wandler, über den die Batterie an den Eingang des Wechselrichters angeschlossen ist, so betrieben, dass mit der Leistung des Wandlers eine Leistungsänderungsrate der Photovoltaikanlage innerhalb eines vorgegebenen Leistungsänderungsbands gehalten wird, wenn sie mit der Leistung des Photovoltaikgenerators kombiniert wird. Auf diese Weise wird das Nachverfolgen der Betriebsspannung des Photovoltaikgenerators maximaler Leistung durch den Wechselrichter nicht behindert.

Die DE 20 23 522 A offenbart ein Verfahren zur automatischen, optimalen Leistungsanpassung einer Gleichstrom-Energieerzeugungseinheit, die einen Photovoltaikgenerator aufweist. An den Ausgang des Photovoltaikgenerators ist ein Direktwandler angeschlossen, der elektrische Leistung aus dem Photovoltaikgenerator einem Konstantspannungsverbraucher zuführt. Weiter ist an den Ausgang des Photovoltaikgenerators ein Laderegler einer Speicherbatterie angeschlossen, die über ein Entladeregler ebenfalls an den Gleichspannungsverbraucher angeschlossen ist. Wenn der Photovoltaikgenerator nicht ausreichend Energie erzeugt, wird Energie aus der Speicherbatterie an den Konstantspannungsverbraucher geliefert. Die Steuerung des Ladereglers der Speicherbatterie erfolgt so, dass der Photovoltaikgenerator immer in der Nähe seiner Betriebsspannung maximaler Leistung betrieben wird.

Aus der EP 1 986 306 A1 ist ein Photovoltaiksystem bekannt, bei dem einem Photovoltaikgenerator, der an einen Wechselrichter angeschlossen ist, eine Reihenschaltung einer Speicherbatterie und eines Schalters parallel geschaltet ist. Mit dem Schalter wird zwischen reiner Leistung von dem Photovoltaikgenerator und kombinierter Leistung von dem Photovoltaikgenerator und der Speicherbatterie umgeschaltet. Bei geöffnetem Schalter wird der Photovoltaikgenerator so betrieben, dass mit dem Wechselrichter seine Betriebsspannung maximaler Leistung nachverfolgt wird. Bei geschlossenem Schalter wird die Spannung der Speicherbatterie die Betriebsspannung des Photovoltaikgenerators.

### AUFGABE DER ERFINDUNG

Der Erfindung liegt die Aufgabe zugrunde, ein Verfahren zum Betrieb einer Photovoltaikanlage mit einem Energiespeicher und einen Wandler zum Anschluss eines Energiespeichers aufzuzeigen, die eine Nachrüstung einer bestehenden Photovoltaikanlage mit einem Energiespeicher ermöglichen, bei dessen Betrieb sowohl die Funktionalität des Auffindens des MPP eines angeschlossenen Photovoltaikgenerators erhalten bleibt, als auch eine vorgegebene Sollleistung unabhängig von Schwankungen der aktuellen Generatorleistung bereitgestellt wird.

### LÖSUNG

Die Aufgabe der Erfindung wird durch ein Verfahren mit den Merkmalen des unabhängigen Patentanspruchs 1 und durch einen Wandler mit den Merkmalen des Patentanspruchs 13 gelöst. Die abhängigen Patentansprüche betreffen bevorzugte Ausführungsformen des Verfahrens und des Wandlers.

### BESCHREIBUNG DER ERFINDUNG

Ein erfindungsgemäßes Verfahren ist zum Betrieb einer Photovoltaikanlage mit einem Wechselrichter, mit einem an einen Eingang des Wechselrichters angeschlossenen Photovoltaikgenerator, mit einem Energiespeicher für elektrische Energie und mit einem bidirektionalen Wandler vorgesehen, über den der Energiespeicher parallel zu dem Photovoltaikgenerator an den Eingang des Wechselrichters angeschlossen ist. Genauer ist das Verfahren für eine solche Photovoltaikanlage vorgesehen, bei der der Wechselrichter eine Betriebsspannung des Photovoltaikgenerators an dem Eingang vorgibt und zum Nachverfolgen einer Betriebsspannung maximaler Leistung von dem Photovoltaikgenerator eingerichtet ist. Anders gesagt weist der Wechselrichter einen MPP-Tracker auf. Zur Vermeidung einer Kollision zwischen diesem MPP-Tracker und dem bidirektionalen Wandler wird von dem Wandler ein zeitlicher Verlauf der von dem Photovoltaikgenerator abgegebenen Leistung erfasst. Basierend hierauf wird der Wandler in einem Betriebsmodus, der als Kompensationsmodus bezeichnet wird, so betrieben, dass er Schwankungen der Leistung des Photovoltaikgenerators gegenüber einer über den Eingang in den Wechselrichter fließenden Sollleistung kompensiert. Diese Leistungskompensation hat zur Folge, dass der Wechselrichter bei Veränderung der Betriebsspannung an dem Eingang keine größere Leistung über den Eingang erhält und entsprechend keine Veränderung der Betriebsspannung vornimmt, um eine von der aktuellen Betriebsspannung abweichende Betriebsspannung maximaler Leistung aufzufinden. Das heißt, in diesem Betriebsmodus des Wandlers ist der MPP-Tracker des Wechselrichters zwar ebenfalls aktiv, aber wirkungslos. Umgekehrt erlaubt dieser Betriebsmodus eine solche Kompensation von Schwankungen der Leistung des Photovoltaikgenerators, dass mit der Photovoltaikanlage trotz dieser Leistungsschwankungen eine konstante elektrische Leistung bereitgestellt werden kann. Zudem wird der MPP-Tracker des Wechselrichters auch nicht durch unkoordinierte Leistungsschwankungen des Wandlers zu einer falschen Betriebsspannung maximaler Leistung geleitet.

Um das Nachverfolgen der Betriebsspannung maximaler Leistung von dem Photovoltaikgenerator durch den Wechselrichter dennoch nutzen zu können, wird der Wandler bei dem erfindungsgemäßen Verfahren in einem anderen Betriebsmodus, der als Trackingmodus bezeichnet wird, so betrieben, dass er das Nachverfolgen der Betriebsspannung maximaler Leistung ermöglicht. Dies kann beispielsweise so geschehen, wie es aus der DE 10 2012 002 185 A1 bekannt ist, indem nämlich der Wandler in diesem anderen Betriebsmodus eine konstante Leistung über den Eingang an den Wechselrichter abgibt oder von dem Photovoltaikgenerator aufnimmt.

Bei dem erfindungsgemäßen Verfahren erfolgt in einem laufenden Betrieb der Photovoltaikanlage, in dem Leistung von dem Photovoltaikgenerator verfügbar ist, also am Tag, ein wiederholter Wechsel zwischen den beiden Betriebsmodi des Wandlers. Die Phasen, in denen der Wandler in dem Trackingmodus betrieben wird, um ein Nachfolgen der Betriebsspannung maximaler Leistung durch den Wechselrichter zu ermöglichen, können dabei als Unterbrechungen des Betriebsmodus des Wandlers angesehen werden, in denen er wunschgemäß Leistungsschwankungen des Photovoltaikgenerator gegenüber der über den Eingang in den Wechselrichter fließenden Sollleistung kompensiert. Diese Unterbrechungen können dann auf ein nötiges Mindestmaß beschränkt werden, weil während dieser Unterbrechungen die angestrebte Kompensation von Schwankungen der Leistung des Photovoltaikgenerators nicht erfolgen kann.

Der Wechsel von dem Kompensationsmodus in den Trackingmodus erfolgt bei dem erfindungsgemäßen Verfahren also möglichst selten, typischerweise aber doch mindestens einmal pro Stunde. Von dem Trackingmodus kann dann jeweils schnell zurück in den Kompensationsmodus gewechselt werden, typischerweise spätestens nach zwei Minuten.

Grundsätzlich kann auch nach festen vorgegebenen Zeiträumen zwischen dem Kompensationsmodus und dem Betriebsmodus gewechselt werden. Dieses Vorgehen trägt jedoch der aktuellen Entwicklung der Betriebszustände nicht Rechnung. Von daher ist es bevorzugt, wenn in dem Kompensationsmodus aus dem zeitlichen Verlauf der von dem Photovoltaikgenerator abgegebenen Leistung auf die Betriebsspannung maximaler Leistung geschlossen wird und wenn nur dann von dem Kompensationsmodus in den Trackingmodus des Wandlers gewechselt wird, wenn die aktuelle Betriebsspannung an dem Eingang über ein vorgegebenes Maß hinaus von der so prognostizierten Betriebsspannung maximaler Leistung abweicht. Dabei kann das vorgegebene Maß so bestimmt sein, dass eine maximale Einbuße an Leistung von dem Photovoltaikgenerator wegen Nichteinhaltens der Betriebsspannung maximaler Leistung auf einen bestimmten Prozentsatz oder Absolutwert beschränkt wird.

In dem Trackingmodus kann der Wandler insbesondere so betrieben werden, dass er das Nachverfolgen der Betriebsspannung maximaler Leistung durch den Wechselrichter unterstützt. Hierzu kann er zusätzliche Leistungsänderungen in Abhängigkeit von Änderungen der Betriebsspannung an dem Eingang hervorrufen, die gleichsinnig zu den Leistungsänderungen des Photovoltaikgenerators in Abhängigkeit von den Änderungen der Betriebsspannung an dem Eingang sind. Auf diese Weise kann das Nachverfolgen bzw. Wiederauffinden der Betriebsspannung maximaler Leistung durch den Wechselrichter erheblich beschleunigt werden. Dies wiederum ermöglicht es, die Phase oder den Zeitraum, in der/dem der Wandler in dem Trackingmodus und damit nicht in dem Kompensationsmodus betrieben wird, zu minimieren.

Eine mögliche Optimierung des Vorgehens zur Unterstützung der MPP-Suche im Trackingmodus besteht darin, die gleichsinnige Leistungsänderung in Zeitpunkt und/oder Höhe zu variieren. Zum Beispiel kann bei bekannten MPP-Suchverfahren über die Höhe einer Leistungsänderung die Sprungweite des MPP-Algorithmus beeinflusst werden, so dass eine Annäherung der Generatorspannung an eine prognostizierte Betriebsspannung maximaler Leistung beschleunigt werden kann. Andererseits kann der Wandler durch Beobachtung des Betriebsspannungsverlaufs des Photovoltaikgenerators Zeitpunkte der Leistungsbestimmung seitens des Wechselrichters erkennen und Zeitpunkte der Bereitstellung der gleichsinnigen Leistungsänderung darauf anpassen. Optional kann der Wandler auch nur für diese Zeitpunkte der Leistungsbestimmung temporär die gleichsinnige Leistungsänderung bereitstellen. Ebenso denkbar ist ein gezieltes Auslösen einer globalen MPP-Suche seitens des Wechselrichters durch geeignete Wahl der gleichsinnigen Leistungsänderung. Auch eine solche globale MPP-Suche kann zu einer Beschleunigung des Erreichens der Betriebsspannung maximaler Leistung führen.

Dennoch versteht sich, dass von dem Trackingmodus erst dann wieder in den Kompensationsmodus des Wandlers gewechselt werden sollte, wenn die Betriebsspannung an dem Eingang die prognostizierte Betriebsspannung maximaler Leistung zumindest bis auf eine vorgegebene maximale Abweichung erreicht hat. Eine Überprüfung dieses Kriteriums ist bei dem erfindungsgemäßen Verfahren möglich, wenn während eines vorangegangenen Zeitraums in dem Kompensationsmodus die Betriebsspannung maximaler Leistung aus dem zeitlichen Verlauf der von dem Photovoltaikgenerator abgegebenen Leistung bestimmt wurde. Selbstverständlich ist nicht ausgeschlossen, dass der von dem Wandler prognostizierte Wert der Betriebsspannung maximaler Leistung auch im Trackingmodus mithilfe der Leistungsdaten des Photovoltaikgenerators laufend korrigiert wird.

Bei dem erfindungsgemäßen Verfahren kann ein Wechsel von dem Kompensationsmodus in den Trackingmodus gezielt blockiert werden, wenn der zeitliche Verlauf der von dem Photovoltaikgenerator abgegebenen Leistung Hinweise darauf enthält, dass aktuell keine von dem Wechselrichter auffindbare Betriebsspannung maximaler Leistung existiert. Es gibt bestimmte Verschattungskonstellationen, in denen ein übliches MPP-Tracking nicht dazu führt, dass die Betriebsspannung maximaler Leistung gefunden wird, weil sie beispielsweise zu weit entfernt von der aktuellen Betriebsspannung an dem Eingang liegt, die aktuelle Leistung einer zu schnellen zeitlichen Veränderung unterliegt oder ein Leistungsmaximum nicht ausreichend deutlich ausgeprägt ist. In diesen Fällen, die an dem Wandler aus dem zeitlichen Verlauf der von dem Photovoltaikgenerator abgegebenen Leistung erkannt werden können, kann der Wandler entweder den Wechsel in den Trackingmodus blockieren, bis diese Randbedingungen entfallen, oder er unterstützt das Auffinden einer allein durch den MPP-Tracker des Wechselrichters nicht auffindbaren Betriebsspannung maximaler Leistung durch gezielte Änderungen der von ihm abgegebenen Leistung in Abhängigkeit von Änderungen der Betriebsspannung an dem Eingang. Letzteres ist aber nur dann möglich, wenn zumindest an dem Wandler aus dem zeitlichen Verlauf der von dem Photovoltaikgenerator abgegebenen Leistung verlässlich auf die tatsächliche Betriebsspannung maximaler Leistung geschlossen werden kann.

Bei dem erfindungsgemäßen Verfahren kann der zeitliche Verlauf der von dem Photovoltaikgenerator abgegebenen Leistung gefiltert und können daraus die Schwankungen der Leistung des Photovoltaikgenerators bestimmt werden, die der Wandler in dem Kompensationsmodus gegenüber der Sollleistung kompensiert. Durch das Filtern können beispielsweise sehr hochfrequente Anteile der Schwankungen der Leistung des Photovoltaikgenerators ausgeblendet werden, die entweder irrelevant sind oder von dem Wechselrichter sowieso ausgeglichen werden. Auf diese Weise können unnötige und den Wandler sowie den darüber angeschlossenen Energiespeicher belastende Schwankungen der kompensierenden Leistung des Wandlers vermieden werden.

Besonders belastend für den Wandler bzw. den daran angeschlossenen Energiespeicher ist häufig eine Umkehr der Energieflussrichtung durch den Wandler. So kann es bevorzugt sein, dass Schwankungen der Leistung des Photovoltaikgenerators, deren Kompensation zu einer wiederholten Umkehr der Energieflussrichtung durch den Wandler führen würden, in dem Kompensationsmodus nicht kompensiert werden. Dies kann zumindest für solche Leistungsschwankungen des Photovoltaikgenerators gelten, die unter einem Energie- und/oder Leistungsdifferenzgrenzwert bleiben. Dabei ist unter Leistungsschwankungen, die unter einem Energiedifferenzgrenzwert bleiben, zu verstehen, dass sich diese Leistungsschwankungen zumindest teilweise selbst ausmitteln. Alternativ stellt der Energiedifferenzgrenzwert sicher, dass Leistungsschwankungen des Photovoltaikgenerators zunächst über einen Mindestzeitraum vorliegen müssen, bevor eine Umkehr der Energieflussrichtung eingeleitet wird.

Es ist grundsätzlich bekannt, dass unterschiedliche Speichermedien für elektrische Energie unterschiedlich sensibel auf Schwankungen der von ihnen abgegebenen oder in sie eingespeisten elektrischen Leistung reagieren. Dabei sind die Speichermedien, die gegenüber solchen Leistungsschwankungen weniger empfindlich sind, jedoch häufig mit anderen Nachteilen verbunden, beispielsweise erhöhten Kosten bezogen auf ihre Speicherkapazität. Daher ist es häufig bevorzugt, wenn mit dem Wandler elektrische Energie in verschiedenen Teilspeichern des Energiespeichers gespeichert und daraus wieder entnommen wird, wobei die Teilspeicher nach ihrer Eignung für schwankende Leistungen und/oder Umkehr der Energieflussrichtung hierarchisch angeordnet sind und beansprucht werden. Zu diesem Zweck kann auch der Wandler in Teilwandler unterteilt sein, die jeweils nur einem der parallel geschalteten Teilspeicher zugeordnet sind. Das heißt jeder der Teilspeicher ist über einen Teilwandler des Wandlers parallel zu dem Photovoltaikgenerator an den Eingang des Wechselrichters angeschlossen.

Die Sollleistung, die über den Eingang in den Wechselrichter fließen soll und zu deren Einhaltung der Energiespeicher über den Wandler zumindest in dem Kompensationsmodus des Wandlers genutzt wird, kann von einem Energiemanagementsystem vorgegeben werden. Dieses Energiemanagementsystem kann ausgelegt sein, einen Eigenverbrauch der von der Photovoltaikanlage bereitgestellten Leistung zu maximieren. Hiermit kann die Belastung eines Wechselstromnetzes, an das die Photovoltaikanlage weiterhin angeschlossen ist, minimiert werden. Ein anderes Ziel des Energiemanagementsystems kann es sein, das Wechselstromnetz mit der dorthin eingespeisten Leistung zu stabilisieren oder einen maximalen Preis für die in das Wechselstromnetz eingespeiste elektrische Leistung zu erzielen.

Bei einer Ausführungsform des erfindungsgemäßen Verfahrens wird der Wandler in dem Kompensationsmodus so betrieben, dass er Schwankungen der Summe der Leistung des Photovoltaikgenerators und eines zweiten Photovoltaikgenerators, der an einen zweiten Eingang des Wechselrichters angeschlossen ist, gegenüber einer über den Eingang und den zweiten Eingang in den Wechselrichter fließenden Sollleistung kompensiert. Dazu sind dann auch die Betriebsspannung an dem zweiten Eingang und der von dem zweiten Photovoltaikgenerator über den zweiten Eingang in den Wechselrichter fließende Strom zu erfassen. Mehrere an denselben Eingang des Wechselrichters angeschlossene Photovoltaikgeneratoren können bei dem neuen Verfahren hingegen genauso wie ein einziger Photovoltaikgenerator berücksichtigt werden.

Ein erfindungsgemäßer bidirektionaler Wandler für den Anschluss eines Energiespeichers für elektrische Energie parallel zu einem Photovoltaikgenerator an den Eingang eines Wechselrichters, wobei der Wechselrichter eine Betriebsspannung des Photovoltaikgenerators an dem Eingang vorgibt und zum Nachverfolgen einer Betriebsspannung maximaler Leistung von dem Photovoltaikgenerator eingerichtet ist, ist dadurch gekennzeichnet, dass er eine an Messeinrichtungen für die Spannung an dem Eingang und den Strom von dem Photovoltaikgenerator angeschlossene Steuerung aufweist, die das erfindungsgemäße Verfahren ausführt. Die Steuerung ist vorzugsweise an mindestens eine Kommunikationsschnittstelle für eine Kommunikation mit einem Energiemanagementsystem und/oder den Wechselrichter und/oder den Photovoltaikgenerator angeschlossen. Von dem Energiemanagementsystem kann die Steuerung die Sollleistung empfangen. Von dem Wandler kann die Steuerung unter anderem die Betriebsspannung an dem Eingang empfangen. Von dem Photovoltaikgenerator kann die Steuerung den von diesem fließenden Strom empfangen. So bedarf der erfindungsgemäße Wandler nicht zwingend eigener Messeinrichtungen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Die Erfindung wird im Folgenden anhand von Ausführungsbeispielen unter Bezugnahme auf die beigefügten Figuren näher erläutert und beschrieben.
- **Fig. 1**: zeigt eine Photovoltaikanlage, die nach dem erfindungsgemäßen Verfahren betrieben wird; und
- **Fig. 2**: ist ein Flussdiagramm einer Ausführungsform eines erfindungsgemäßen Verfahrens.

### FIGURENBESCHREIBUNG

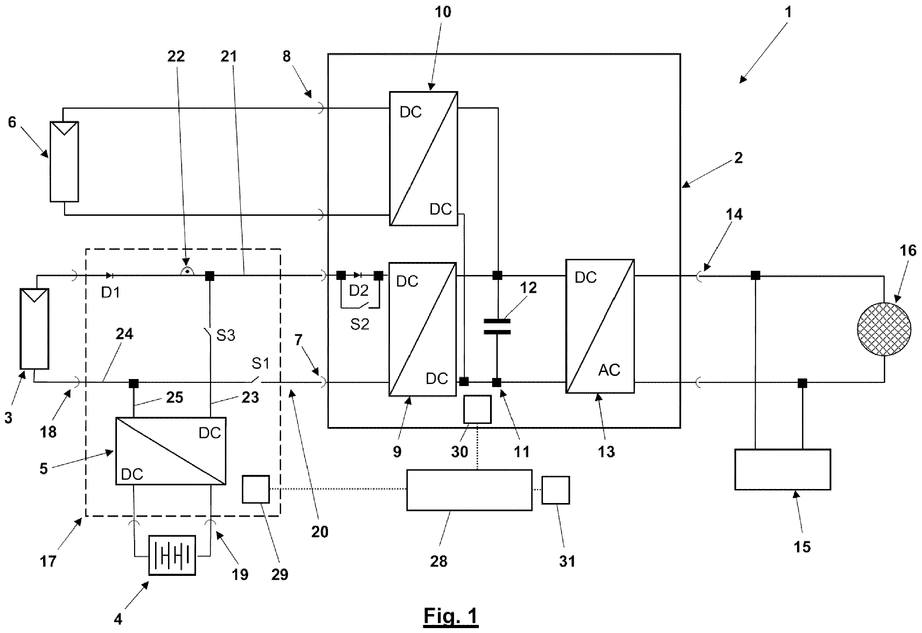

Die in **Fig. 1** gezeigte Photovoltaikanlage 1 weist als für die vorliegende Erfindung wesentliche Bestandteile einen Wechselrichter 2, einen ersten Photovoltaikgenerator 3, einen Energiespeicher 4 und einen bidirektionalen Wandler 5 auf. Neben dem ersten Photovoltaikgenerator 3 ist noch ein zweiter Photovoltaikgenerator 6 vorgesehen. Die Photovoltaikgeneratoren 3 und 6 sind an separate Eingänge 7 und 8 des Wechselrichters 2 angeschlossen. Für jeden der Eingänge 7 und 8 weist der Wechselrichter 2 einen DC/DC-Wandler 9 bzw. 10 auf, über den der jeweilige Eingang 7 bzw. 8 an einen gemeinsamen Gleichspannungszwischenkreis 11 mit einem Zwischenkreiskondensator 12 angeschlossen ist. Aus dem Gleichspannungszwischenkreis 11 speist sich ein DC/AC-Wandler 13 des Wechselrichters 2, der an einem Ausgang 14 des Wechselrichters 2 einen Wechselstrom ausgibt. Dieser Wechselstrom wird, soweit er nicht von einem der Photovoltaikanlage 1 lokal zugeordneten Verbraucher 15 verbraucht wird, in ein Wechselstromnetz 16 eingespeist.

Die separaten DC/DC-Wandler 9 und 10 für die Eingänge 7 und 8 dienen dazu, für die Photovoltaikgeneratoren 3 und 6 Betriebsspannungen an den Eingängen 7 und 8 vorzugeben, bei denen eine maximale Leistung von den Photovoltaikgeneratoren 3 und 6 erhalten wird. Diese Betriebsspannungen maximaler Leistung können bei den Photovoltaikgeneratoren 3 und 6 voneinander abweichen, und auch bei jedem der Photovoltaikgeneratoren 3 und 6 verändern sie sich über den Tag hinweg und mit variierenden Verschattungsbedingungen, insbesondere durch Wolken. Das Verfolgen der Betriebsspannung maximaler Leistung wird auch als MPP (Maximum Power Point)-Tracking und die DC/DC-Wandler 9 und 10 entsprechend als MPP-Tracker bezeichnet. Bei einer erfindungsgemäßen Photovoltaikanlage 1 ist der zweite Eingang 8 mit dem zugehörigen zweiten DC/DC-Wandler 10 für den zweiten Photovoltaikgenerator 6 nur eine Option.

Über den Wandler 5 ist der Energiespeicher 4 parallel zu dem ersten Photovoltaikgenerator 3 an den Eingang 7 des Wechselrichters 2 angeschlossen. Der Energiespeicher 4 ist hier als Batterie angedeutet; entsprechend ist der bidirektionale Wandler 5 ein DC/DC-Wandler. Gemäß Fig. 1 ist der Wandler 5 Teil einer Wandlereinheit 17 mit einem Generatoreingang 18, einem Speichereingang 19 und einem Ausgang 20. An den Generatoreingang 18 ist der erste Photovoltaikgenerator 3 angeschlossen. An den Speichereingang 19 ist der Energiespeicher 4 angeschlossen; und der Ausgang 20 ist an den Eingang 7 des Wechselrichters 2 angeschlossen. In einer Leitung 21, die einen Pol des Generatoreingangs 18 mit einem Pol des Ausgangs 20 verbindet, sind eine Diode D1 und ein Stromsensor 22 vorgesehen, und es zweigt eine Leitung 23 zu dem Wandler 5 ab, in der ein Schalter S3 vorgesehen ist. In einer Leitung 24, die den anderen Pol des Generatoreingangs 18 mit dem Ausgang 20 verbindet, ist ein Schalter S1 vorgesehen, und es zweigt eine weitere Leitung 25 zu dem Wandler 5 ab. In der Fortsetzung der Leitung 21 ist zwischen dem Eingang 7 und dem DC/DC-Wandler 9 eine Diode D2 vorgesehen, der ein optionaler Schalter S2 parallel geschaltet ist. Die Diode D1 kann durch einen aktiven Schalter (nicht dargestellt) ersetzt sein.

Die Dioden D1 und D2 dienen zum Schutz vor Fehlströmen in den ersten Photovoltaikgenerator 3 bzw. aus dem Wechselrichter 2. Mit den Schaltern S1 bis S3 können der Energiespeicher 4 und der Wechselrichter 2 paarweise miteinander verbunden werden. Der Schalter S2 ermöglicht es dabei, auch elektrische Leistung von dem zweiten Photovoltaikgenerator 6 über den Zwischenkreis 11 in den Energiespeicher 4 einzuspeisen. Im Einzelnen kann zum ausschließlichen Laden des Energiespeichers 4 mit Hilfe des ersten Photovoltaikgenerators 3 der Schalter S3 geschlossen und der Schalter S1 geöffnet werden. Zum ausschließlichen Entladen des Energiespeichers 4 in den Wechselrichter 2 werden beide Schalter S3 und S1 geschlossen, und der Wandler 5 prägt eine höhere Spannung ein als der erste Photovoltaikgenerator 3, um die Diode D1 zu sperren. Alternativ kann der optional anstelle der Diode D1 vorgesehene Schalter geöffnet werden. Zum Laden des Energiespeichers 4 aus dem zweiten Photovoltaikgenerator 6 ist neben den Schaltern S1 und S3 auch der Schalter S2 zu schließen und, wenn nicht auch aus dem ersten Photovoltaikgenerator 3 geladen werden soll, der optional anstelle der Diode D1 vorhandene Schalter zu öffnen.

In einer weiteren, nicht gezeigten Ausführungsform der Erfindung ist an dem Eingang 8 parallel zum zweiten Photovoltaikgenerator 6 eine weitere Wandlereinheit angeschlossen, deren Aufbau und Funktion der Wandlereinheit 17 entspricht, so dass jede Wandlereinheit einem der Photovoltaikgeneratoren 3, 6 zugeordnet ist. Hierbei ist es nicht nur möglich, dass beide Wandlereinheiten eigene Energiespeicher aufweisen, sondern auch, dass sie sich einen gemeinsamen Energiespeicher 4 teilen.

Bei noch einer weiteren, nicht gezeigten Ausführungsform der Erfindung werden lediglich Strom und Spannung des zweiten Photovoltaikgenerators 6 einzeln oder als kombinierter Leistungswert an die Wandlereinheit 17 übertragen. Dafür können zusätzliche Messeinrichtungen vorgesehen sein oder sowieso vorhandene Messeinrichtungen des Wechselrichters 2 für die Spannung an dem Eingang 8 und den Strom von dem zweiten Photovoltaikgenerator 6 verwendet werden. Zur Bestimmung der wie nachfolgend beschrieben zu kompensierenden Leistungsschwankung wird dann nicht nur die Leistung des ersten Photovoltaikgenerators 3 berücksichtigt, sondern die Summe der Leistung beider Photovoltaikgeneratoren 3 und 6 zugrunde gelegt.

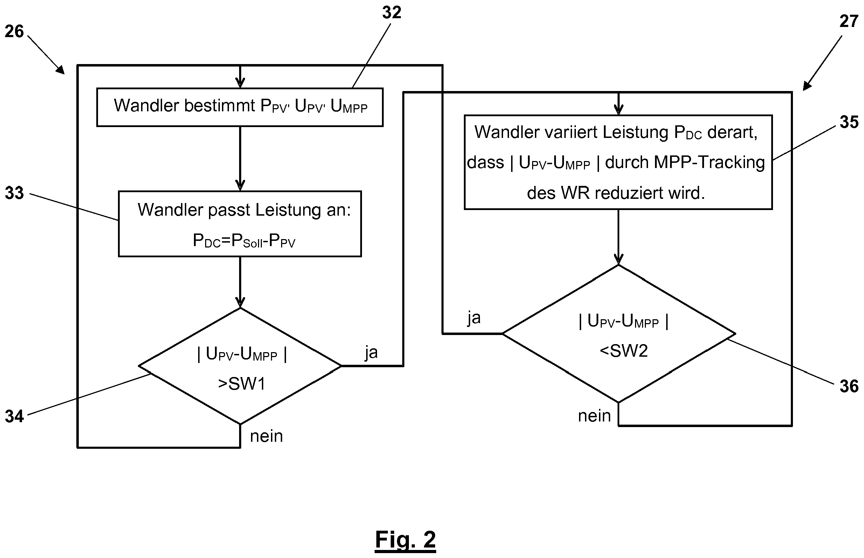

Die bis hier beschriebenen Betriebsmodi der Photovoltaikanlage 1 ermöglichen es jedoch nicht, Leistungsschwankungen des Photovoltaikgenerators 3 im laufenden Betrieb der Photovoltaikanlage 1 mit Hilfe des Energiespeichers 4 auszugleichen. Um diesen Ausgleich zu erreichen, ohne dabei mit dem MPP-Tracking des Wechselrichters 2 für den Photovoltaikgenerator 3 durch den DC/DC-Wandler 9 zu kollidieren, ist ein in **Fig. 2** in Form eines Ablaufdiagramms gezeigtes Verfahren vorgesehen. Das Verfahren weist eine in Fig. 2 links dargestellte Schleife auf, die einem Kompensationsbetrieb 26 des Wandlers 5 entspricht, und eine in Fig. 2 rechts dargestellte Schleife, die einem Trackingmodus 27 des Wandlers 5 entspricht. Als Grundlage für das in Fig. 2 illustrierte Verfahren dienen der mit dem Stromsensor 22 gemäß Fig. 1 erfasste Strom, die Betriebsspannung U_{PV} an dem Eingang 7, eine aus dem Strom und der Betriebsspannung durch Multiplikation bestimmte Leistung P_{PV} und deren Verlauf über der Zeit, die in der Wandlereinheit 17 bestimmt werden. Darüber hinaus wird der Wandlereinheit eine Sollleistung P_{Soll} vorgegeben. In Fig. 1 ist angedeutet, dass dies über ein Energiemanagementsystem 28 erfolgt, das mit einer Steuerung 29 des Wandlers 5, einer Steuerung 30 des Wechselrichters 2 und externen Stellen 31 kommuniziert. Diese externen Stellen 31 können z. B. den Verbrauch des Verbrauchers 15 dokumentieren, so dass das Energiemanagement 28 einen Eigenverbrauch der von der Photovoltaikanlage 1 erzeugten elektrischen Leistung durch den Verbraucher 15 optimieren kann.

In einem Schritt 32 gemäß Fig. 2 werden an dem Wandler 5, d. h. in der Wandlereinheit 17, gemäß Fig. 1 die aktuelle Leistung P_{PV} des Photovoltaikgenerators 3, die Betriebsspannung U_{PV} und aus dem zeitlichen Verlauf der Leistung auch die aktuell prognostizierte (nicht anliegende) Betriebsspannung U_{MPP} maximaler Leistung von dem Photovoltaikgenerator 3 bestimmt. In einem nachfolgenden Schritt 33 wird in dem Kompensationsmodus die von dem Wandler 5 an den Eingang 7 abgegebene (oder dort abgezweigte) Leistung P_{DC} so angepasst, dass eine Differenz zwischen der Sollleistung P_{Soll} und der Leistung P_{PV} des Photovoltaikgenerators 3 ausgeglichen wird, so dass die Summe der Wandlerleistung P_{DC} und der Generatorleistung P_{PV} der Sollleistung P_{Soll} entspricht. In einem nachfolgenden Schritt 34 wird überprüft, ob die aktuelle Betriebsspannung U_{PV} von der Betriebsspannung U_{MPP} um mehr als eine erste Schwelle SW1 abweicht. Wenn dies der Fall ist, wird in den Trackingmodus 27 gewechselt, sonst beginnt die Schleife des Kompensationsmodus 26 erneut mit dem Schritt 32. Im Trackingmodus 27 hält der Wandler seine Leistung P_{DC} konstant oder variiert sie derart, das die Differenz zwischen der aktuellen Betriebsspannung U_{PV} und der prognostizierten Betriebsspannung U_{MPP} maximaler Leistung durch das MPP-Tracking des Wechselrichters reduziert wird. Dazu kann der Wandler 5 seine Leistung P_{DC} insbesondere gleichsinnig zu den Änderungen der Leistung P_{PV} des Photovoltaikgenerators 3 mit Änderungen der Betriebsspannung U_{PV} variieren, um das MPP-Tracking zu beschleunigen. In einem nachfolgenden Schritt 36 wird geprüft, inwieweit sich die aktuelle Spannung U_{PV} bereits an die in dem Kompensationsmodus 26 bestimmte prognostizierte Betriebsspannung U_{MPP} maximaler Leistung angenähert hat. Wenn dies bis unter eine zweite Schwelle SW2 erfolgt ist, wird von dem Trackingmodus 27 zurück in den Kompensationsmodus 26 gewechselt. Alternativ kann der Trackingmodus 27 auch solange beibehalten werden, wie eine Abweichung der an dem Eingang 7 des Wechselrichters 2 eingespeisten Leistung, d. h. der Summe der Leistungen P_{DC} und P_{PV}, von der Sollleistung P_{Soll} eine dafür gesetzte Schwelle nicht überschreitet, weil solange auch keine Änderung der Leistung P_{DC} des Wandlers 5 gemäß Fig. 1 angezeigt ist.

### BEZUGSZEICHENLISTE

- 1: Photovoltaikanlage
- 2: Wechselrichter
- 3: Photovoltaikgenerator
- 4: Energiespeicher
- 5: Wandler
- 6: Photovoltaikgenerator
- 7: Eingang
- 8: Eingang
- 9: DC/DC-Wandler
- 10: DC/DC-Wandler
- 11: Gleichspannungszwischenkreis
- 12: Kondensator
- 13: DC/AC-Wandler
- 14: Ausgang
- 15: Verbraucher
- 16: Wechselstromnetz
- 17: Wandlereinheit
- 18: Generatoreingang
- 19: Speichereinheit
- 20: Ausgang
- 21: Leitung
- 22: Stromsensor
- 23: Leitung
- 24: Leitung
- 25: Leitung
- 26: Kompensationsmodus
- 27: Trackingmodus
- 28: Energiemanagementsystem
- 29: Steuerung
- 30: Steuerung
- 31: Stelle
- 32: Schritt
- 33: Schritt
- 34: Schritt
- 35: Schritt
- 36: Schritt
- S1, S2, S3: Schalter
- D1, D2: Diode
- SW1, SW2: Schwelle
- P_{PV}: Leistung des Photovoltaikgenerators 3
- U_{PV}: Betriebsspannung am Eingang 7
- U_{MPP}: Betriebsspannung maximaler Leistung des Photovoltaikgenerators 3
- P_{DC}: Leistung des Wandlers 5
- P_{Soll}: Sollleistung

## Patentansprüche

1. Verfahren zum Betrieb einer Photovoltaikanlage (1) mit einem Wechselrichter (2), mit einem an einen Eingang (7) des Wechselrichters (2) angeschlossenen Photovoltaikgenerator (3), wobei der Wechselrichter (2) eine Betriebsspannung (U_{PV}) des Photovoltaikgenerators (3) an dem Eingang (7) vorgibt und zum Nachverfolgen einer Betriebsspannung (U_{MPP}) maximaler Leistung von dem Photovoltaikgenerator (3) eingerichtet ist, mit einem Energiespeicher (4) für elektrische Energie und mit einem bidirektionalen Wandler (5), über den der Energiespeicher (4) parallel zu dem Photovoltaikgenerator (3) an den Eingang (7) des Wechselrichters (2) angeschlossen ist, wobei der Wandler (5) in einem Trackingmodus (27) so betrieben wird, dass er das Nachverfolgen der Betriebsspannung (U_{MPP}) maximaler Leistung durch den Wechselrichter (2) ermöglicht,
**dadurch gekennzeichnet,**
- **dass** der Wandler (5) in einem Kompensationsmodus (26) so betrieben wird, dass er Schwankungen der Leistung (P_{PV}) des Photovoltaikgenerators (3) gegenüber einer über den Eingang (7) in den Wechselrichter (2) fließenden Sollleistung (P_{Soll}) kompensiert, indem er die von ihm an den Eingang (7) abgegebene oder von dort abgezweigte Leistung (P_{DC}) so anpasst, dass die Summe der Leistung (P_{DC}) des Wandlers (5) und der Leistung (P_{PV}) des Photovoltaikgenerators (3) gleich der Sollleistung (P_{Soll}) ist, wobei ein zeitlicher Verlauf, und damit die Schwankungen, der von dem Photovoltaikgenerator (3) abgegebenen Leistung (P_{PV}) von dem Wandler (5) erfasst wird und
- **dass** in einem laufenden Betrieb der Photovoltaikanlage (1), in dem Leistung (P_{PV}) von dem Photovoltaikgenerator (3) verfügbar ist, wiederholt zwischen dem Kompensationsmodus (26) und dem Trackingmodus (27) gewechselt wird.

2. Verfahren nach Anspruch 1, **dadurch gekennzeichnet, dass** im laufenden Betrieb der Photovoltaikanlage (1) mindestens einmal pro Stunde von dem Kompensationsmodus (26) in den Trackingmodus (27) gewechselt wird und spätestens nach zwei Minuten von dem Trackingmodus (27) zurück in den Kompensationsmodus (26) gewechselt wird.

3. Verfahren nach Anspruch 1 oder 2, **dadurch gekennzeichnet, dass** nach fest vorgegebenen Zeiträumen zwischen dem Kompensationsmodus (26) und dem Trackingmodus (27) gewechselt wird.

4. Verfahren nach Anspruch 1 oder 2, **dadurch gekennzeichnet, dass** in dem Kompensationsmodus (26) aus dem zeitlichen Verlauf der von dem Photovoltaikgenerator (3) abgegebenen Leistung (P_{PV}) auf die Betriebsspannung (U_{MPP}) maximaler Leistung geschlossen wird und dass von dem Kompensationsmodus (26) in den Trackingmodus (27) des Wandlers (5) gewechselt wird, wenn die aktuelle Betriebsspannung (U_{PV}) an dem Eingang (7) über ein vorgegebenes Maß hinaus von der Betriebsspannung (U_{MPP}) maximaler Leistung abweicht.

5. Verfahren nach Anspruch 4, **dadurch gekennzeichnet, dass** der Wandler (5) in dem Trackingmodus (27) so betrieben wird, dass er das Nachverfolgen der Betriebsspannung (U_{MPP}) maximaler Leistung durch den Wechselrichter (2) mit zusätzlichen gleichsinnigen Leistungsänderungen in Abhängigkeit von Änderungen der Betriebsspannung (U_{PV}) an dem Eingang (7) unterstützt, die gleichsinnig zu denjenigen des Photovoltaikgenerators (3) sind.

6. Verfahren nach Anspruch 4 oder 5, **dadurch gekennzeichnet, dass** von dem Trackingmodus (27) in den Kompensationsmodus (26) des Wandlers (5) gewechselt wird, wenn die Betriebsspannung (U_{PV}) an dem Eingang (7) die Betriebsspannung (U_{MPP}) maximaler Leistung zumindest bis auf eine vorgegebene maximale Abweichung erreicht hat.

7. Verfahren nach einem der Ansprüche 1 bis 6, **dadurch gekennzeichnet, dass** ein Wechsel von dem Kompensationsmodus (26) in den Trackingmodus (27) blockiert wird, wenn der zeitliche Verlauf der von dem Photovoltaikgenerator (3) abgegebenen Leistung (P_{PV}) darauf hinweist, dass aktuell keine von dem Wechselrichter (2) auffindbare Betriebsspannung (U_{MPP}) maximaler Leistung existiert.

8. Verfahren nach einem der Ansprüche 1 bis 7, **dadurch gekennzeichnet, dass** der zeitliche Verlauf der von dem Photovoltaikgenerator (3) abgegebenen Leistung (P_{PV}) gefiltert wird und daraus die Schwankungen der Leistung (P_{PV}) des Photovoltaikgenerators (3) bestimmt werden, die der Wandler (5) in dem Kompensationsmodus (26) gegenüber der Sollleistung (P_{Soll}) kompensiert.

9. Verfahren nach einem der Ansprüche 1 bis 8, **dadurch gekennzeichnet, dass** Schwankungen der Leistung (P_{PV}) des Photovoltaikgenerators (3), deren Kompensation zu einer Umkehr der Energieflussrichtung durch den Wandler (5) führen würde und unter einem Energie- und/oder Leistungsdifferenzgrenzwert bleiben, in dem Kompensationsmodus (26) nicht kompensiert werden.

10. Verfahren nach einem der Ansprüche 1 bis 9, **dadurch gekennzeichnet, dass** mit dem Wandler (5) elektrische Energie in verschiedenen Teilspeichern des Energiespeichers gespeichert und daraus wieder entnommen wird, wobei die Teilspeicher nach ihrer Eignung für schwankende Leistungen (P_{DC'}) und/oder eine Umkehr der Energieflussrichtung hierarchisch geordnet sind und beansprucht werden.

11. Verfahren nach einem der Ansprüche 1 bis 10, **dadurch gekennzeichnet, dass** die Sollleistung (P_{Soll}) von einem Energiemanagementsystem (28) vorgegeben wird, mit dem eine Maximierung eines Eigenverbrauchs der von der Photovoltaikanlage (1) bereitgestellten Leistung verfolgt wird.

12. Verfahren nach einem der Ansprüche 1 bis 11, **dadurch gekennzeichnet, dass** der Wandler (5) in dem Kompensationsmodus (26) so betrieben wird, dass er Schwankungen der Summe der Leistung (P_{PV}) des Photovoltaikgenerators (3) und eines an einen zweiten Eingang (8) des Wechselrichters (2) angeschlossenen zweiten Photovoltaikgenerators (6) gegenüber einer über den Eingang (7) und den zweiten Eingang (8) in den Wechselrichter (2) fließenden Sollleistung (P_{Soll}) kompensiert.

13. Bidirektionaler Wandler (5) für den Anschluss eines Energiespeichers (4) für elektrische Energie parallel zu einem Photovoltaikgenerator (3) an den Eingang (7) eines Wechselrichters (2), wobei der Wechselrichter (2) eine Betriebsspannung (U_{PV}) des Photovoltaikgenerators (3) an dem Eingang (7) vorgibt und zum Nachverfolgen einer Betriebsspannung (U_{MPP}) maximaler Leistung von dem Photovoltaikgenerator (3) eingerichtet ist, **dadurch gekennzeichnet, dass** eine an Messeinrichtungen für Strom und Spannung des Photovoltaikgenerators (3) anschließbare Steuerung (29) vorhanden ist, die zur Ausführung des Verfahrens nach einem der Ansprüche 1 bis 12 eingerichtet ist.

14. Bidirektionaler Wandler (5) nach Anspruch 13 zur Ausführung des Verfahrens nach Anspruch 12, **dadurch gekennzeichnet, dass** die Steuerung auch an Messeinrichtungen für Strom und Spannung des zweiten Photovoltaikgenerators (6) anschließbar ist.

15. Bidirektionaler Wandler (5) nach Anspruch 13 oder 14, **dadurch gekennzeichnet, dass** die Steuerung an mindestens eine Kommunikationsschnittstelle für eine Kommunikation mit einem Energiemanagementsystem (28) und/oder dem Wechselrichter (2) und/oder dem Photovoltaikgenerator (3) angeschlossen ist.

## Claims

1. A method for operating a photovoltaic system (1) with an inverter (2), with a photovoltaic generator (3) connected to an input (7) of the inverter (2), wherein the inverter (2) controls an operating voltage (U_{PV}) of the photovoltaic generator (3) at the input (7) and is arranged for tracking an maximum power operating voltage (U_{MPP}) of the photovoltaic generator (3), with an energy store (4) for electrical energy and with a bidirectional converter (5) via which the energy store (4) is connected to the input (7) of the inverter (2) in parallel with the photovoltaic generator (3), the converter (5) being operated in a tracking mode (27) such that it enables the inverter (2) to track the maximum power operating voltage (U_{MPP}), **characterized**
- **in that** the converter (5) is operated in a compensation mode (26) in such a way that it compensates fluctuations in the power (P_{PV}) of the photovoltaic generator (3) with respect to a nominal power (P_{Soll}) flowing via the input (7) into the inverter (2) by adapting the power (P_{DC}) delivered by it to or branched from the input (7), such that the sum of the power (P_{DC}) of the converter (5) and the power (P_{PV}) of the photovoltaic generator (3) is equal to the nominal power (P_{Soll}), wherein a time course, and thus the fluctuations, of the power (P_{PV}) output by the photovoltaic generator (3) are detected by the converter (5) and
- **in that** during operation of the photovoltaic system (1),with power (P_{PV}) being available from the photovoltaic generator (3), the compensation mode (26) and the tracking mode (27) are repeatedly interchanged.

2. The method according to claim 1, **characterized in that** during operation of the photovoltaic system (1) the tracking mode (27) is switched from the compensation mode (26) at least once per hour and the tracking mode (27) is switched back to the compensation mode (26) at the latest after two minutes.

3. The method according to claim 1 or 2, **characterized by** switching between the compensation mode (26) and the tracking mode (27) after fixed predetermined periods of time.

4. The method according to claim 1 or 2, **characterized in that** in the compensation mode (26) the maximum power operating voltage (U_{MPP}) is derived from the time course of the power (P_{PV}) delivered by the photovoltaic generator (3) and that the converter (5) is switched from the compensation mode (26) to the tracking mode (27) if the current operating voltage (U_{PV}) at the input (7) deviates from the maximum power operating voltage (U_{MPP}) beyond a predetermined amount.

5. The method according to claim 4, **characterized in that** the converter (5) is operated in the tracking mode (27) such that it supports the tracking of the maximum power operating voltage (U_{MPP}) by the inverter (2) with additional concordant power changes depending on changes in the operating voltage (U_{PV}) at the input (7) which are in the same direction as those of the photovoltaic generator (3).

6. The method according to claim 4 or 5, **characterized in that** the tracking mode (27) is switched to the compensation mode (26) of the converter (5) when the operating voltage (U_{PV}) at the input (7) has reached the maximum power operating voltage (U_{MPP}) at least up to a predetermined maximum deviation.

7. The method according to one of claims 1 to 6, **characterized in that** a change from the compensation mode (26) to the tracking mode (27) is blocked if the time course of the power (P_{PV}) delivered by the photovoltaic generator (3) indicates that currently no maximum power operating voltage (U_{MPP}) exists that can be found by the inverter (2).

8. The method according to one of claims 1 to 7, **characterized in that** the time course of the power (P_{PV}) output by the photovoltaic generator (3) is filtered and the fluctuations in the power (P_{PV}) of the photovoltaic generator (3) are determined therefrom, and are compensated by the converter (5) in the compensation mode (26) with respect to the target power (P_{Soll}).

9. The method according to one of claims 1 to 8, **characterized in that** fluctuations in the power (P_{PV}) of the photovoltaic generator (3), the compensation of which would lead to a reversal of the energy flow direction through the converter (5) and remain below an energy and/or power difference limit value, are not compensated in the compensation mode (26).

10. The method according to one of claims 1 to 9, **characterized in that** electrical energy is stored with the converter (5) in various partial stores of the energy store and taken out of them again, the partial stores being arranged and utilized hierarchically according to their suitability for fluctuating powers (P_{DC}) and/or for a reversal of the energy flow direction.

11. The method according to one of claims 1 to 10, **characterized in that** the target power (P_{target}) is specified by an energy management system (28) directed to a maximization of an internal consumption of the power provided by the photovoltaic system (1).

12. The method according to one of claims 1 to 11, **characterized in that** the converter (5) is operated in the compensation mode (26) in such a way that it compensates for fluctuations in the sum of the power (P_{PV}) of the photovoltaic generator (3) and a second photovoltaic generator (6) connected to a second input (8) of the inverter (2) with respect to a nominal power (P_{Soll}) flowing via the input (7) and the second input (8) into the inverter (2).

13. A bidirectional converter (5) for connecting an energy store (4) for electrical energy parallel to a photovoltaic generator (3) to the input (7) of an inverter (2), wherein the inverter (2) controls an operating voltage (U_{PV}) of the photovoltaic generator (3) at the input (7) and is arranged to track a maximum power operating voltage (U_{MPP}) from the photovoltaic generator (3), **characterized in that** a controller (29) is provided connectable to measuring devices for current and voltage of the photovoltaic generator (3) and arranged to perform the method according to one of claims 1 to 12.

14. The bidirectional converter (5) according to claim 13 for performing the method according to claim 12, **characterized in that** the controller is also connectable to measuring devices for current and voltage of the second photovoltaic generator (6).

15. The bidirectional converter (5) according to claim 13 or 14, **characterized in that** the controller is connected to at least one communication interface for communication with an energy management system (28) and/or the inverter (2) and/or the photovoltaic generator (3).

## Revendications

1. Procédé, destiné à faire fonctionner une installation photovoltaïque (1), pourvue d'un onduleur (2), d'un générateur photovoltaïque (3) raccordé sur une entrée (7) de l'onduleur (2), l'onduleur (2) prédéfinissant une tension de service (U_{PV}) du générateur photovoltaïque (3) sur l'entrée (7) et étant aménagé pour suivre une tension de service (U_{MPP}) à puissance maximale du générateur photovoltaïque (3), pourvue d'un accumulateur d'énergie (4) pour de l'énergie électrique et pourvue d'un convertisseur bidirectionnel (5), par l'intermédiaire duquel l'accumulateur d'énergie (4) est raccordé à la parallèle du générateur photovoltaïque (3) sur l'entrée (7) de l'onduleur (2), dans un mode de suivi (27), le convertisseur (5) fonctionnant de sorte à permettre le suivi de la tension de service (U_{MPP}) à puissance maximale par l'onduleur (2),
**caractérisé**
- **en ce que** dans un mode de compensation (26), le convertisseur (5) fonctionne de sorte à compenser des fluctuations de la puissance (P_{PV}) du générateur photovoltaïque (3) par rapport à une puissance de consigne (P_{Soll}) circulant par l'intermédiaire de l'entrée (7) dans l'onduleur (2), en adaptant la puissance (P_{DC}) qu'il a restituée sur l'entrée (7) ou dérivée à partir de celle-ci de telle sorte que la somme de la puissance (P_{DC}) du convertisseur (5) et de la puissance (P_{PV}) du générateur photovoltaïque (3) soit égale à la puissance de consigne (P_{Soll}), une courbe temporelle, et ainsi les fluctuations, de la puissance (P_{PV}) restituée par le générateur photovoltaïque (3) étant détectée par le convertisseur (5) et
- **en ce que** lors d'un fonctionnement continu de l'installation photovoltaïque (1), lors duquel de la puissance (P_{PV}) du générateur photovoltaïque (3) est disponible, il est permuté de manière répétée entre le mode de compensation (26) et le mode de suivi (27).

2. Procédé selon la revendication 1, **caractérisé en ce qu'**en fonctionnement continu de l'installation photovoltaïque (1), il est permuté au moins une fois par heure du mode de compensation (26) dans le mode de suivi (27) et au plus tard après deux minutes, du mode de suivi (27) en retour dans le mode de compensation (26).

3. Procédé selon la revendication 1 ou 2, **caractérisé en ce que** selon des périodes fixement prédéfinies, il est permuté entre le mode de compensation (26) et le mode de suivi (27).

4. Procédé selon la revendication 1 ou 2, **caractérisé en ce que** dans le mode de compensation (26), à partir de la courbe temporelle de la puissance (P_{PV}) restituée par le générateur photovoltaïque (3) est déduite la tension de service (U_{MPP}) à puissance maximale et **en ce qu'**il est permuté du mode de compensation (26) dans le mode de suivi (27) du convertisseur (5) si la tension de service (U_{PV}) actuelle sur l'entrée (7) diverge au-delà d'une dimension prédéfinie de la tension de service (U_{MPP}) à puissance maximale.

5. Procédé selon la revendication 4, **caractérisé en ce que** dans le mode de suivi (27), le convertisseur (5) fonctionne de sorte à assister le suivi de la tension de service (U_{MPP}) à puissance maximale par l'onduleur (2) avec des variations de puissance de même sens supplémentaires, en fonction de variations de la tension de service (U_{PV}) sur l'entrée (7) qui sont dans le même sens que celles du générateur photovoltaïque (3).

6. Procédé selon la revendication 4 ou 5, **caractérisé en ce qu'**il est permuté du mode de suivi (27) dans le mode de compensation (26) du convertisseur (5) si la tension de service (U_{PV}) sur l'entrée (7) a atteint la tension de service (U_{MPP}) à puissance maximale, au moins jusqu'à un écart maximal prédéfini.

7. Procédé selon l'une quelconque des revendications 1 à 6, **caractérisé en ce qu'**une permutation du mode de compensation (26) dans le mode de suivi (27) est bloquée si la courbe temporelle de la puissance (P_{PV}) restituée par le générateur photovoltaïque (3) indique qu'il n'existe actuellement aucune tension de service (U_{MPP}) à puissance maximale, susceptible d'être trouvée par l'onduleur (2).

8. Procédé selon l'une quelconque des revendications 1 à 7, **caractérisé en ce que** la courbe temporelle de la puissance (P_{PV}) restituée par le générateur photovoltaïque (3) est filtrée et à partir de celle-ci, les fluctuations de la puissance (P_{PV}) du générateur photovoltaïque (3) que le convertisseur (5) compense par rapport à la puissance de consigne (P_{Soll}) dans le mode de compensation (26) sont déterminées.

9. Procédé selon l'une quelconque des revendications 1 à 8, **caractérisé en ce que** des fluctuations de la puissance (P_{PV}) du générateur photovoltaïque (3), dont la compensation mènerait à une inversion de la direction du flux d'énergie à travers le convertisseur (5) et qui restent sous une valeur limite de puissance et/ou d'énergie différentielle ne sont pas compensées dans le mode de compensation (26).

10. Procédé selon l'une quelconque des revendications 1 à 9, **caractérisé en ce qu'**avec le convertisseur (5), de l'énergie électrique est accumulée dans différents accumulateurs partiels de l'accumulateur d'énergie et en est à nouveau retirée, les accumulateurs partiels étant hiérarchiquement ordonnés et mis à contribution en fonction de leur aptitude à des puissances fluctuantes (P_{DC'}) et/ou à une inversion de la direction du flux d'énergie.

11. Procédé selon l'une quelconque des revendications 1 à 10, **caractérisé en ce que** la puissance de consigne (P_{Soll}) est prédéfinie par un système de gestion d'énergie (28), lequel assure le suivi d'une maximisation d'une consommation énergétique de la puissance mise à disposition par l'installation photovoltaïque (1).

12. Procédé selon l'une quelconque des revendications 1 à 11, **caractérisé en ce que** dans le mode de compensation (26), le convertisseur(5) fonctionne de sorte à compenser des fluctuations de la somme de la puissance (P_{PV}) du générateur photovoltaïque (3) et d'un deuxième générateur photovoltaïque (6) raccordé sur une deuxième entrée (8) de l'onduleur (2) par rapport à une puissance de consigne (P_{Soll}) circulant par l'intermédiaire de l'entrée (7) et de la deuxième entrée (8) dans l'onduleur (2).

13. Convertisseur bidirectionnel (5), destiné au raccordement d'un accumulateur d'énergie (4) pour de l'énergie électrique, à la parallèle d'un générateur photovoltaïque (3) sur l'entrée (7) d'un onduleur (2), l'onduleur (2) prédéfinissant une tension de service (U_{PV}) du générateur photovoltaïque (3) sur l'entrée (7) et étant aménagé pour le suivi d'une tension de service (U_{MPP}) à puissance maximale par le générateur photovoltaïque (3), **caractérisé en ce qu'**un système de commande (29) susceptible d'être raccordé sur des systèmes de mesure du courant et de la tension du générateur photovoltaïque (3) est présent, lequel est aménagé pour réaliser le procédé selon l'une quelconque des revendications 1 à 12.

14. Convertisseur bidirectionnel (5) selon la revendication 13, destiné à réaliser le procédé selon la revendication 12, **caractérisé en ce que** le système de commande est également susceptible d'être raccordé sur des systèmes de mesure du courant et de la tension du deuxième générateur photovoltaïque (6).

15. Convertisseur bidirectionnel (5) selon la revendication 13 ou 14, **caractérisé en ce que** le système de commande est raccordé sur au moins une interface de communication pour une communication avec un système de gestion d'énergie (28) et/ou avec l'onduleur (2) et/ou avec le générateur photovoltaïque (3).
